(19) Europäisches Patentamt / European Patent Office / Office européen des brevets

(11) **EP 4 340 304 A1**

(12) **EUROPEAN PATENT APPLICATION**

(43) Date of publication:
**20.03.2024 Bulletin 2024/12**

(21) Application number: **22196395.2**

(22) Date of filing: **19.09.2022**

(51) International Patent Classification (IPC):
**H04L 25/03** (2006.01)      **H03M 13/41** (2006.01)
**H03M 13/00** (2006.01)

(52) Cooperative Patent Classification (CPC):
**H04L 25/03203; H03M 13/4138; H03M 13/6331;
H04L 25/03197; H04L 25/03318;** H03M 13/3961

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Nokia Solutions and Networks Oy
02610 Espoo (FI)**

(72) Inventor: **LEFEVRE, Yannick
3001 Heverlee (BE)**

(74) Representative: **Louis Pöhlau Lohrentz
Patentanwälte
Postfach 30 55
90014 Nürnberg (DE)**

(54)    **METHOD AND APPARATUS FOR AN EQUALIZER BASED ON VITERBI ALGORITHM**

(57)    The present invention discloses an apparatus, comprising means for performing: obtaining, by an equalizer based on Viterbi algorithm in a receiver in a communication link, for a first possible state (s) of a received sample at the current time step (k), log-likelihood ratio, llr, values $llr_{old,min}$, $llr_{old,max}$ of a first transmitted bit ($b_j$), wherein, the llr values $llr_{old,min}$, $llr_{old,max}$ are respectively associated with a most likely state ($s'_{min}$) and a less likely state ($s'max$) related to a received sample at the previous time step (k-1); determining, by the equalizer, based on path metrics and branch metrics corresponding to the received sample at the current time step (k); a first parameter (Q) related to a difference between likelihoods of the most likely state ($s'_{min}$) and the less likely state ($s'max$); updating, by the equalizer, magnitude of the llr value $llr_{old,min}$ at least based on the llr value $llr_{old,min}$, the llr value $llr_{old,max}$, and the first parameter, thereby obtaining an updated llr value $llr_{old,updated}$.

```
obtaining llr values llr_{old,min},        S810
llr_{old,max} of a first transmitted bit b_j
          |
          v
determining a first parameter              S820
related to a difference between
likelihoods of the most likely state
s'_{min} and the less likely state s'_{max}
          |
          v
updating magnitude of the llr              S830
value llr_{old,min} at least based on
the llr value llr_{old,min}, the llr value
llr_{old,max}, and the first parameter
```

Fig. 8

EP 4 340 304 A1

**Description**

Field of the invention

Various example embodiments relate to an apparatus and a method for use by an equalizer based on the Viterbi algorithm in a receiver in a communication link.

Background

Next-generation passive optical networks (PONs) are used to deliver broadband access. PON systems have a point-to-multi-point (P2MP) topology, in which one optical line terminal (OLT) at the network side is used to connect to a multitude (e.g., up to 64) of optical network units (ONUs) at the user side by means of an optical distribution network (ODN) or fiber plant that contains optical fibers and splitters, but no active components. It is noted that, pertaining to the present disclosure, the terminology ONU and ONT for Optical Network Terminal may be used interchangeably.

Due to cost reasons, it is expected that next-generation passive optical networks (PON) standards will employ bandwidth-limited reception. For instance, 50G PON may be received using 25G optics. Such bandwidth limitation causes significant inter-symbol-interference (ISI), i.e., received samples do not only depend on the corresponding transmitted symbol, but are also affected by the previous and/or following symbols.

In addition, due to the increased line rate speeds, next-generation PON systems will be more strongly affected by chromatic dispersion due to the fiber propagation, leading to even more ISI.

While for lower-rate PON technologies, the impact of ISI is small and hence can easily be dealt with or even neglected, this does not hold anymore for 25G/50G PON systems due to the reasons listed above (bandwidth-limited reception and increased impact of dispersion). As a result, to recover the symbols that are corrupted by ISI and enable reliable communication, next-generation PON technologies may use an (electrical) analog-to-digital converter (ADC) at the receiver in combination with digital signal processing (DSP)-based channel equalization and forward error correcting (FEC) techniques. The channel equalizer deals with ISI and provides an interference-free (or with reduced interference) receive symbol sequence to the FEC decoder. The FEC decoder further corrects the errors in the receive sequence using redundancy introduced at the transmitter.

Channel equalization is a well-known DSP technique to mitigate ISI in digital communication systems. A near-optimal approach consists of Maximum Likelihood Sequence Estimation (MLSE) in case of a hard-output equalizer. However, the computational complexity of this approach grows exponentially with the channel dispersion time. A well-known efficient MLSE implementation utilizes the Viterbi algorithm.

An important drawback of the traditional MLSE algorithm (or Viterbi algorithm) is that the outputs are hard decisions, meaning binary data symbol estimations. There exist also algorithm variants that output soft decisions or llrs, for example BCJR (Bahl, Cocke, Jelinek and Raviv) and Soft-Output Viterbi Equalizer (SOVE). However these either have a much higher complexity, or a reduced soft-output performance.

Summary of the Invention

Thus, an objective of the invention is to provide a soft-output MLSE or Viterbi-based algorithm, that has a low or even minimal complexity, without compromising on the performance.

The object of the invention is achieved by the subject matters according to the claims.

According to a first aspect of the present invention, there is provided an apparatus, comprising means for performing: obtaining, by an equalizer based on Viterbi algorithm in a receiver in a communication link, for a first possible state $(s)$ of a received sample at the current time step $(k)$, log-likelihood ratio, llr, values $llr_{old, min}$, $llr_{old,max}$ of a first transmitted bit $(bj)$, wherein, the llr values $llr_{old, min}$, $llr_{old,max}$ are respectively associated with a most likely state $(s'_{min})$ and a less likely state $(s'_{max})$ related to a received sample at the previous time step $(k-1)$; determining, by the equalizer, based on path metrics and branch metrics corresponding to the received sample at the current time step $(k)$; a first parameter $(Q)$ related to a difference between likelihoods of the most likely state $(s'_{min})$ and the less likely state $(s'max)$; updating, by the equalizer, magnitude of the llr value $llr_{old, min}$ at least based on the llr value $llr_{old, min}$, the llr value $llr_{old,max}$, and the first parameter, thereby obtaining an updated llr value $llr_{old,updated}$.

According to a second aspect of the present invention, there is provided a method comprising: obtaining, by an equalizer based on Viterbi algorithm in a receiver in a communication link, for a first possible state $(s)$ of a received sample at the current time step $(k)$, log-likelihood ratio, llr, values $llr_{old, min}$, $llr_{old,max}$ of a first transmitted bit $(bj)$, wherein, the llr values $llr_{old, min}$, $llr_{old,max}$ are respectively associated with a most likely state $(s'_{min})$ and a less likely state $(s'_{max})$ related to a received sample at a previous time step $(k-1)$; determining, by the equalizer, based on path metrics and branch metrics corresponding to the received sample at the current time step $(k)$; a first parameter related to a difference between likelihoods of the most likely state $(s'_{min})$ and the less likely state $(s'max)$; updating, by the equalizer, magnitude of the llr value $llr_{old,\,min}$ at least based on the llr value $llr_{old,\,min}$, the llr value $llr_{old,max}$, and the first parameter, thereby obtaining an updated llr value $llr_{old,updated}$.

According to a third aspect of the present invention, there is provided a computer program comprising instructions which, when the program is executed by a computer, cause the computer to carry out: obtaining, by an equalizer based on Viterbi algorithm in a receiver in a communication link, for a first possible state (s) of a received sample at the current time step (k), log-likelihood ratio, llr, values $llr_{old,\,min}$, $llr_{old,max}$ of a first transmitted bit (bj), wherein, the llr values $llr_{old,\,min}$, $llr_{old,max}$ are respectively associated with a most likely state ($s'_{min}$) and a less likely state ($s'_{max}$) related to a received sample at a previous time step (k-1); determining, by the equalizer, based on path metrics and branch metrics corresponding to the received sample at the current time step (k); a first parameter related to a difference between likelihoods of the most likely state ($s'_{min}$) and the less likely state ($s'_{max}$); updating, by the equalizer, magnitude of the llr value $llr_{old,\,min}$ at least based on the llr value $llr_{old,\,min}$, the llr value $llr_{old,max}$, and the first parameter, thereby obtaining an updated llr value $llr_{old,updated}$.

According to a fourth aspect of the invention, there is provided an apparatus comprising at least one processor and at least one memory including computer program code, the at least one memory and the computer program code configured to with the at least one processor, cause the apparatus at least to perform: obtaining, by an equalizer based on Viterbi algorithm in a receiver in a communication link, for a first possible state (s) of a received sample at the current time step (k), log-likelihood ratio, llr, values $llr_{old,\,min}$, $llr_{old,max}$ of a first transmitted bit (bj), wherein, the llr values $llr_{old,\,min}$, $llr_{old,max}$ are respectively associated with a most likely state ($s'_{min}$) and a less likely state ($s'_{max}$) related to a received sample at a previous time step (k-1); determining, by the equalizer, based on path metrics and branch metrics corresponding to the received sample at the current time step (k); a first parameter related to a difference between likelihoods of the most likely state ($s'_{min}$) and the less likely state (s'max); updating, by the equalizer, magnitude of the llr value $llr_{old,\,min}$ at least based on the llr value $llr_{old,\,min}$, the llr value $llr_{old,max}$, and the first parameter, thereby obtaining an updated llr value $llr_{old,updated}$.

According to a fifth aspect of the invention, there is provided a non-transitory computer readable medium comprising program instructions for causing an apparatus to perform at least the following: obtaining, by an equalizer based on Viterbi algorithm in a receiver in a communication link, for a first possible state (s) of a received sample at the current time step (k), log-likelihood ratio, llr, values $llr_{old,\,min}$, $llr_{old,max}$ of a first transmitted bit (bj), wherein, the llr values $llr_{old,\,min}$, $llr_{old,max}$ are respectively associated with a most likely state ($s'_{min}$) and a less likely state ($s'_{max}$) related to a received sample at a previous time step (k-1); determining, by the equalizer, based on path metrics and branch metrics corresponding to the received sample at the current time step (k); a first parameter related to a difference between likelihoods of the most likely state ($s'_{min}$) and the less likely state (s'max); updating, by the equalizer, magnitude of the llr value $llr_{old,\,min}$ at least based on the llr value $llr_{old,\,min}$, the llr value $llr_{old,max}$, and the first parameter, thereby obtaining an updated llr value $llr_{old,updated}$.

According to a sixth aspect of the invention, there is provided a computer readable medium comprising program instructions for causing an apparatus to perform at least the following: obtaining, by an equalizer based on Viterbi algorithm in a receiver in a communication link, for a first possible state (s) of a received sample at the current time step (k), log-likelihood ratio, llr, values $llr_{old,\,min}$, $llr_{old,max}$ of a first transmitted bit (bj), wherein, the llr values $llr_{old,\,min}$, $llr_{old,max}$ are respectively associated with a most likely state ($s'_{min}$) and a less likely state ($s'_{max}$) related to a received sample at a previous time step (k-1); determining, by the equalizer, based on path metrics and branch metrics corresponding to the received sample at the current time step (k); a first parameter related to a difference between likelihoods of the most likely state ($s'_{min}$) and the less likely state (s'max); updating, by the equalizer, magnitude of the llr value $llr_{old,\,min}$ at least based on the llr value $llr_{old,\,min}$, the llr value $llr_{old,max}$, and the first parameter, thereby obtaining an updated llr value $llr_{old,updated}$.

According to the present invention, a similar structure as the soft-output Viterbi Equalizer (SOVE) algorithm is used, while the $llr_{old,max}$ of a transmitted bit (bj) and associated with the less likely state ($s'_{max}$) related to a received sample at a previous time step (k-1) will not be simply discarded. At every step, the llr magnitudes of the transmitted bit (bj) is updated based on the llr values $llr_{old,\,min}$, $llr_{old,max}$ associated with both the most likely state ($s'_{min}$) and a less likely state ($s'_{max}$). The difference between the log-likelihoods of the most likely state ($s'_{min}$) and the less likely state ($s'_{max}$) is also reflected in the magnitude of the updated llr value. In this way the same performance as the BCJR algorithm can be realized, with a complexity that scales as the hard-output MLSE algorithm. Comparing to BCJR which requires two passes through the trellis, various embodiments require only a single pass through the trellis.

Brief description of the figures

Fig.1 depicts a schematic block diagram of a network topology according to the present application;
Fig. 2 depicts a schematic block diagram of a next-generation PON communication system;

Fig. 3 depicts a schematic diagram of an example trellis of states for illustrating the Viterbi algorithm;
Fig. 4 depicts a schematic block diagram of an example implementation of the Viterbi based MLSE algorithm;
Fig. 5 depicts a schematic block diagram of memory update procedure for the Viterbi based MLSE;
Fig. 6a depicts a schematic block diagram of an example implementation of the BCJR algorithm;
Fig. 6b depicts a schematic block diagram of a path metric calculation block used in an example implementation of the BCJR algorithm;
Fig. 7 depicts a schematic block diagram of an example implementation of the SOVE algorithm;
Fig. 8 depicts a flow diagram of a method for llr updating according to various embodiments;
Fig. 9 depicts a schematic diagram showing the update procedure according to one embodiment;
Fig. 10 depicts a schematic block diagram of implementing llr updating according to one embodiment of the present invention;
Fig. 11 depicts a block diagram of an apparatus according to various embodiments.

Detailed description

Example embodiments of the present application are described herein in detail and shown by way of example in the drawings. It should be understood that, although specific embodiments are discussed herein there is no intent to limit the scope of the invention to such embodiments. To the contrary, it should be understood that the embodiments discussed herein are for illustrative purposes, and that modified and alternative embodiments may be implemented without departing from the scope of the invention as defined in the claims. Embodiments not falling under the scope of the appended claims are to be considered merely as examples suitable for understanding the invention. The sequence of method steps is not limited to the specific embodiments, the method steps may be performed in other possible sequence. Similarly, specific structural and functional details disclosed herein are merely representative for purposes of describing the embodiments. The invention described herein, however, may be embodied in many alternate forms and should not be construed as limited to only the embodiments set forth herein.

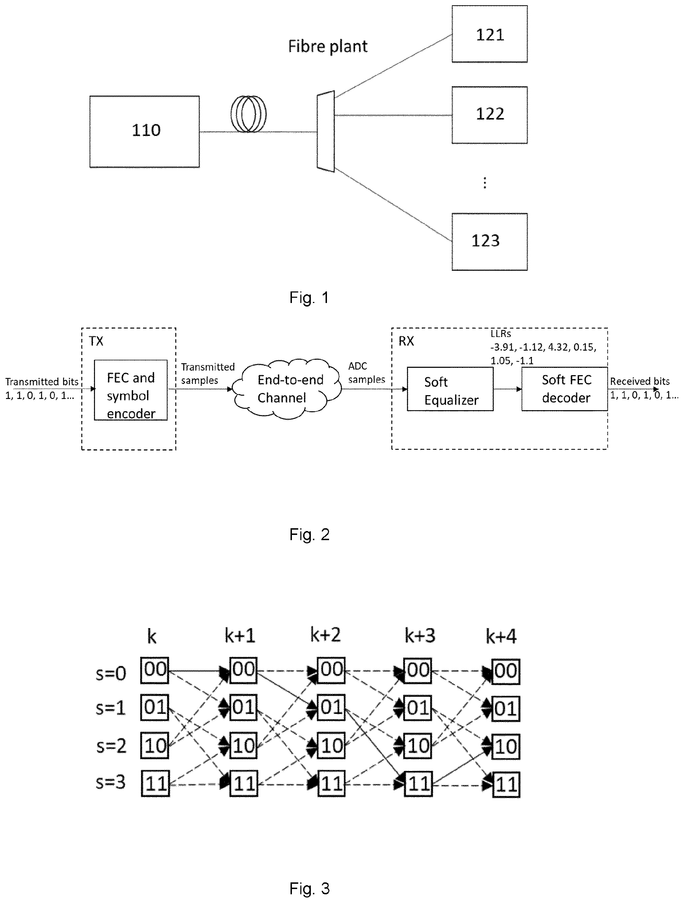

Fig.1 shows a schematic block diagram of a network topology according to the present application.

As shown in Fig. 1 in a PON, an OLT 110 at the network side is used to connect to a plurality of optical network units (ONUs) 121, 122, ..., 123 at the user side by means of an optical distribution network (ODN) or fiber plant that contains optical fibers and splitters, but no active components.

Most PON technologies such as G-PON, E-PON, and XGS-PON are time-division multiplexing (TDM) PON technologies, in which the fiber medium is shared in time between the different ONUs. In addition, time- and wavelength-division multiplexing (TWDM) PON technologies exist, such as NG-PON2, in which multiple TDM systems at different wavelength are stacked on the same PON system. The present invention applies to both TDM and TWDM PON systems.

Fig. 2 shows a schematic block diagram of a next-generation PON communication system.

In Fig. 2, at the transmitter TX, redundant bits are added to the data bits, so the FEC decoder at the receiver can reduce the total number of errors using this redundancy. The 50G PON standard employs low-density parity check (LDPC) codes, which are advanced FEC codes achieving higher FEC gains than the more conventional Reed Solomon codes used by older PON standards. LDPC codes have also the advantage that they can be efficiently decoded while taking into account soft information. This means they can be decoded using the log-likelihood ratios (LLRs) or probabilities of the individual bits rather than only their hard-decisioned binary values. Soft-input LDPC is expected to be used in some 50G implementations, due to its superior FEC gain.

The encoded data bits are then digitally modulated onto symbols. Typically, non-return to zero on-off keying (NRZ-OOK) modulation is used. The digital transmit signal x[k] is hence represented by the binary values +1 or -1 depending on the current (encoded) data bit $b_k$. For example, a bit value $b_k = 0$ corresponds to x[k]=+1, and a bit value $b_k = 1$ corresponds to x[k]=-1. Other (higher-order) modulation formats like, e.g., PAM4 could be used in future PON technologies for which $x[k] \in \left[-1, -\frac{1}{3}, \frac{1}{3}, 1\right]$, or PAM3 for which x[k] $\in$ [-1,0,1].

The transmit signal x[k] is communicated over a dispersive and noisy channel leading to the receive samples y[k], at the output of the ADC. This dispersive and noisy channel includes the fiber propagation as well as the hardware-induced distortion effects.

At the receiver RX, the received samples are processed by a channel equalizer to mitigate the ISI impact and provide an interference-free symbol sequence to the FEC decoder. The latter further corrects the errors in the receive sequence. In case of a soft decoder, the llrs are calculated as log of the ratio of the probabilities of the bit being a 0 given the received samples y to it being a 1:

$$llr_k = \log\left(\frac{P(b_k = 0|\boldsymbol{y})}{P(b_k = 1|\boldsymbol{y})}\right).$$

Maximum Likelihood Sequence Estimation (MLSE) is a well-known near-optimal channel equalization approach. An MLSE equalizer selects the most likely (i.e. the one with maximum likelihood or probability) symbol sequence from all possible transmit sequences, given the received samples. The computational complexity of this approach grows hence exponentially with the length of the channel dispersion time. A well-known efficient MLSE implementation utilizes the Viterbi algorithm to reduce the computational complexity.

Fig. 3 shows a schematic diagram of an example trellis of states for illustrating the Viterbi algorithm.

As illustrated in Fig. 3, the goal of the Viterbi algorithm is to calculate the most probable path through a trellis of states. Consider binary transmission (i.e., $x[k] = \pm 1$) and an L-tap MLSE equalizer where L is the expected number of consecutively transmit symbols that affect any received sample. Consequently, the received samples with ISI may be viewed as the output of a finite state machine, and can thus be represented by a $2^{L-1}$-state trellis diagram. This is illustrated in Fig. 3 in which L=3 and there are 4=2^2 states. The maximum-likelihood estimate of the transmit symbol sequence is simply the most probable path through the trellis, marked with solid arrows, given the receive sample sequence $\boldsymbol{y} = [y_1 \dots y_K]$:

$$\boldsymbol{x}^* = \underset{\boldsymbol{x}}{\mathrm{argmin}} -\log\big(P(\boldsymbol{y}|x_1 \dots x_K)\big),$$

where $P(\boldsymbol{y}|x_1 \dots x_K)$ is the probability that y is observed given that the sequence $\boldsymbol{x} = [x_1,..,x_K]$ is transmitted. The dashed arrows show all other possible transitions between the states.

Viterbi-type algorithms provide an efficient means for performing the trellis search, by sequentially processing all receive samples and pruning unlikely paths at every step. Key is that the optimal path through the trellis is computed incrementally using the previously computed path and branch metrics. The idea is that for each possible state s at a time step k, only 1 of the 2 incoming paths will be retained (the path with the highest probability) while the other path will be discarded. For example, for state "01" at time step k+2, there are two possible incoming paths from previous time step, namely state "00" and state "10" at time step k+1. Only the one with highest probability, i.e. the path from state "00" will be retained. Generally, for each possible state s at time step k, a path from one of the $2^{L-1}$ possible states for the L-1 transmitted symbol sub-sequence $[x_{k-L+2}, \dots, x_k]$ will be retained. Thus, each state s at time step k corresponds to one of the $2^{L-1}$ possible states for the L-1 transmit symbol sub-sequence $[x_{k-L+2}, \dots, x_k]$. In addition, if the path metric $PM[s,k]$ is defined as the minus log-probability of the being in state s at time step k of the trellis (i.e., that the symbols $x_{k-L+2}, \dots, x_k$ corresponding to state s were transmitted), then the $PM[s,k]$ corresponds to:

$$PM[s,k] = -\log\big(P(y_1, \dots, y_k|x_{k-L+2}, \dots, x_k)\big)$$

$$= -\log\left(\sum_{x_{k-L+1}} P(y_k|x_{k-L+1}, \dots, x_k)P(y_1, \dots, y_{k-1}|x_{k-L+1}, \dots, x_{k-1})\right)$$

Note that the values of $x_{k-L+2}, \dots, x_k$ are implicitly specified by the state s (each state s corresponds to a specific set of transmitted symbols $x_{k-L+2}, \dots, x_k$). The PM of state s at time step k can in approximation be computed recursively from the PMs of the two possible predecessor states s' (for the two values of $x_{k-L+1}$) at time index k-1 as:

$$PM[s,k] = \min_{s'}\big[-\log(P(y_k|x_{k-L+1}, \dots, x_k)) + PM[s',k-1]\big],$$

where the minus log of a sum of terms has been approximated as the minimum of the minus logs of the terms (which is a commonly applied approximation in the context of probabilities). Also, the value of $x_{k-L+1}$ is implicitly specified by the state s'. The transition probability, corresponding to the first term inside the argument of the min-function, is defined as the branch metric (BM). Hence, in the trellis search $2^L$ BMs or transition probabilities are calculated at each time step k (i.e., for each received sample $y_k$):

$$BM[s, s', k] = -\log\big(\mathrm{P}(y_k | x_{k-L+1}, \ldots, x_k)\big),$$

where $\mathrm{P}(y_k | x_{k-L+1}, \ldots, x_k)$ is the probability that $y_k$ is observed given that the current transmit sequence is $x_{k-L+1}, \ldots, x_k$. Note that each BM corresponds to the transition from a previous state s' (corresponding to the sequence $x_{k-L+1}, \ldots, x_{k-1}$) to the next state s (corresponding to the sequence $x_{k-L+2}, \ldots, x_k$). For any state s, only the s' states for which the last L-2 symbols of s' are identical to the first L-2 symbols of s are considered. The PMs are thus calculated as:

$$PM[s, k] = \min_{s'}\big[BM[s, s', k] + PM[s', k - 1]\big].$$

For the Viterbi algorithm, the absolute values of the PMs and BMs do not really matter, but only the relative differences (e.g., the differences between the different PMs at time-step k). Hence, the practically calculated values only equal the log probabilities up to an offset (i.e., a constant factor for the probabilities).

The performance of the MLSE equalizer depends on the accuracy of the BM calculation unit. Many BM models can be considered to calculate the transition probabilities. The most common model assumes white additive Gaussian noise, such that

$$\mathrm{P}(y_k | \boldsymbol{x}_i) = \frac{1}{\sqrt{2\pi\sigma_i^2}} e^{-\frac{(y_k - \mu_i)^2}{2\sigma_i^2}}$$

where $\mu_i$ and $\sigma_i^2$ denote respectively the mean and noise variance of the Gaussian pdf corresponding to a received sample given transmitted sequence $x_i$.

More advanced BM models may compute the transition probabilities via histogram metrics measured at the receiver, or based on AI-inspired models.

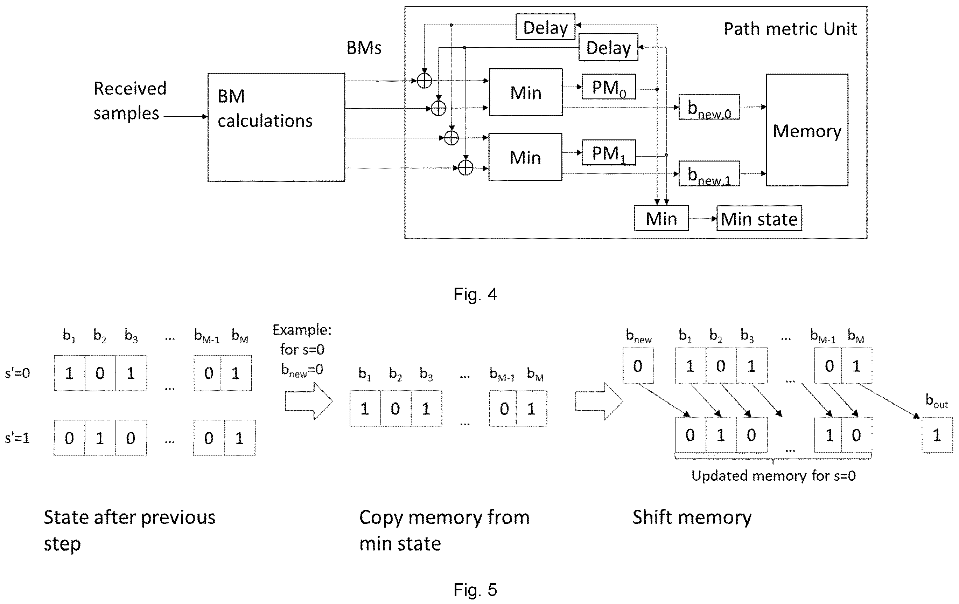

Fig.4 shows a schematic block diagram of an example implementation of the Viterbi based MLSE algorithm.

Fig. 4 illustrates a block diagram of an example implementation of the Viterbi based MLSE algorithm for L=2 (and thus 2^(L-1)=2 states). For every time step, 4 BMs, respectively for transitions from 2 possible states s' (s'=0 and s'=1) at the previous time step $t_{k-1}$ to two possible states s (s=0, and s=1) at the current time step $t_k$, are calculated based on received samples. Then the 4 corresponding BMs are added to the delayed 2 surviving PMs. This leads to the two pairs of temporary PMs, of which pairwise the minimum is calculated, leading to the two surviving PMs, PMo and $PM_1$, each related to one of the two states 0 and 1. For each state, which temporary PM was minimal also determines what the most likely bit that was transmitted according to the surviving path in the state (PMo being minimal implies that 0 was most likely, and $PM_1$ that 1 was most likely). These bit values, $b_{new,0}$ and $b_{new,1}$, one for each state, are then sent to a memory unit.

The memory unit stores for each of the states the most probable bit values of the last M bits, where M is the length of the memory. At each time step, the bit values in the memory are updated, and these updates are calculated separately for each new state. Hence, it is sufficient to focus on the processing for one state, and for simplicity, the dependency on the new state 0/1 is dropped when considering parameters such as bnew.

Fig. 5 shows a schematic block diagram of memory update procedure for the Viterbi based MLSE.

Fig. 5 illustrates how the memory is processed at each time step. At the beginning of the processing, the memory is filled with hard decisions of the last M bits (obtained in the previous M steps) for each of the two previous states s', s'=1 and s'=0. In the example shown in Fig. 5, $b_1$ corresponds to the most recent bit value and $b_M$ to the oldest bit value. Then, focusing on the processing for the first possible state s=0 of the received sample at the current time step k (processing for state s=1 is identical), the memory of the most likely previous state $s'_{min}$ is copied. For example, for the first possible state s=0, $b_{new}=0$, given that the most likely state s'min related to the received sample at the previous time step (k-1) is s'=0 in this example, the memory corresponding to the state s'=0 is copied. After this, all the bits in the memory get shifted by 1 position, while $b_M$ is outputted as $b_{out}$ for the state s=0 and $b_{new}$ is inserted at $b_1$. In this way the memory content for the new state s=0 is obtained. Depending on which one of the possible states s, s=0 or s=1, has a minimum PM (see block 'Min state' in Fig. 4), the $b_{out}$ corresponding to the state having minimum PM will be outputted by the 'Memory' block in Fig. 4. FEC decoding is then performed based on the $b_{out}$ outputted by the 'Memory' block in Fig. 4.

The advantage of this MLSE algorithm is that it has a small complexity compared to other Viterbi-based algorithms. It however has hard output, and therefore has a performance penalty compared to soft-output equalization algorithms.

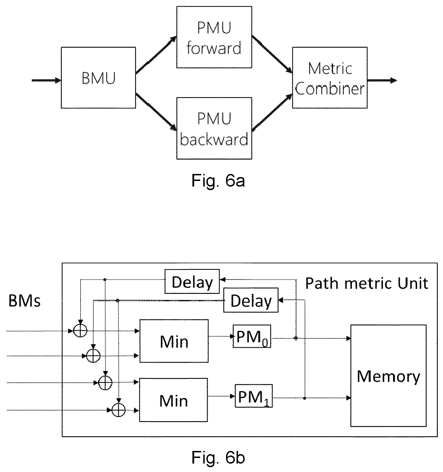

Fig. 6a show a schematic block diagram of an example implementation of the BCJR algorithm.

The BCJR algorithm is a well-known soft-output Viterbi-based equalization algorithm, which yields very good equalization performance. As shown in Fig. 6a, it consists of branch metric unit (BMU), two path metric units (PMU) and a metric combiner. After calculating the branch metrics in the BMU, two sets of path metrics are calculated: forward path metrics are calculated via a forward pass of the Viterbi algorithm (in the PMU forward), and backward path metrics are calculated via a backward pass (in the PMU backward). Both sets of path metrics are then combined (i.e., added together) in the metric combiner to calculate the total path metrics. These path metrics (indicating the log of the likelihoods) can then be used to calculate the llrs.

Fig. 6b shows a schematic block diagram of a path metric calculation block used in an example implementation of the BCJR algorithm.

The path mertic calculation block shown in Fig. 6b is somewhat similar to Fig. 4, with the difference that the memory stores all path metrics, rather than the M most recent bit values.

It is clear that the BCJR algorithm is significantly more complex than the MLSE algorithm, as it requires two passes through the trellis (i.e., two sets of path metric calculations). It also requires to store all the path metrics of the trellis in memory. So while the BCJR achieves the best performance, it does so at more than twice the complexity than the MLSE algorithm.

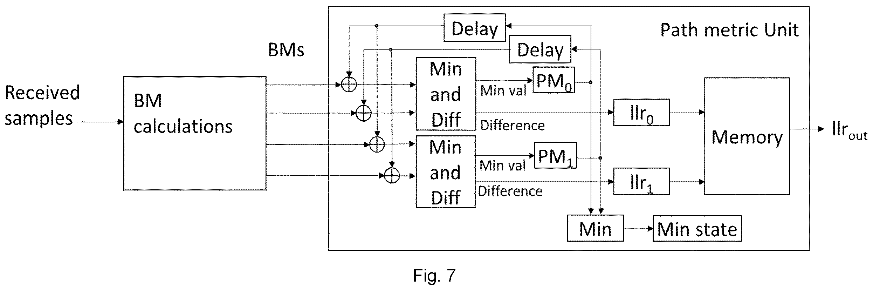

Fig. 7 shows a schematic block diagram of an example implementation of the SOVE algorithm.

A soft-output Viterbi-based algorithm that has lower complexity than the MLSE is the soft-output Viterbi Equalizer (SOVE). In the SOVE algorithm, the llrs are only calculated based on the forward pass. A block diagram example is given in Fig. 7. In the considered example (with two states), an llr for the current bit can be calculated for each state by considering the difference between the two temporary path metric. These llrs (llr0 and llr1) can then be stored in the memory, similar to how $b_0$ and $b_1$ are stored for the MLSE algorithm in Fig. 4. The llrs are then processed similarly as in Fig. 5, but with the bits $b_1, \ldots, b_M$ replaced by llrs $llr_1, \ldots, llr_M$.

Since the SOVE algorithm only relies on a single pass, it has roughly only half the complexity compared to the BCJR. However, the quality of the llrs is significantly worse, as it only considers the forward path metrics (i.e., only half the information), which leads to an overestimation of the llr magnitudes. This leads to a significant degradation in performance compared to the BCJR algorithm.

Other soft-output Viterbi algorithms have been proposed, such as for instance the soft-output Viterbi Algorithm (SOVA). These algorithms have typically a complexity somewhere between the SOVE and the BCJR algorithm, and for instance consider more states or path metric differences than the SOVE algorithm. While the performance is typically better than that of the SOVE, it still remains below that of the BCJR algorithm.

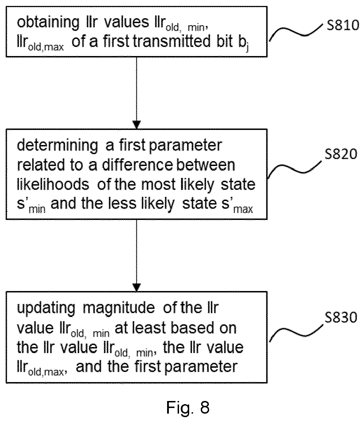

Fig. 8 shows a flow diagram of a method for llr updating according to various embodiments.

Various aspects may be implemented in a receiver in a communication link. For example, various aspects may be implemented in an OLT or an ONU. Generally, various aspects may be implemented in any receiver in a communication link affected by ISI.

Specifically, in step S810, an equalizer based on Viterbi algorithm in a receiver in a communication link obtains for a first possible state s of a received sample at the current time step k, log-likelihood ratio, llr, values $llr_{old, min}$, $llr_{old,max}$ of a first transmitted bit bj, wherein, the llr values $llr_{old, min}$, $llr_{old,max}$ are respectively associated with a most likely state $s'_{min}$ and a less likely state $s'_{max}$ related to the received sample at the previous time step k-1.

For simplicity, the states of the received sample at the current time step k may be written as the current state s, and the states of the received sample at the previous time step k-1 may be written as previous state s'.

The number of possible states is related to L and the modulation schemed used. For example, given that the transmitted samples are binary modulated, there may be $2^{L-1}$ possible states. In another embodiment, in case of PAM4 modulation and L=3, there are $4^{L-1}=16$ possible states.

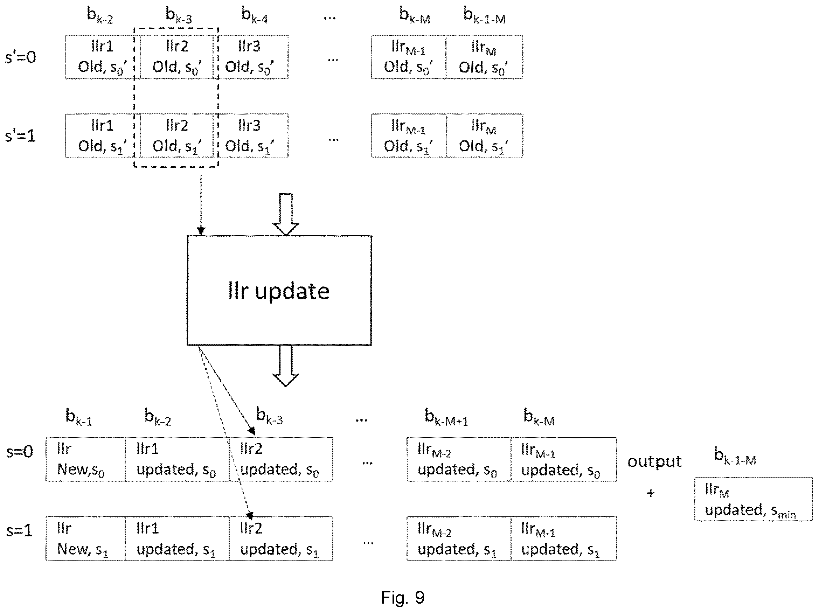

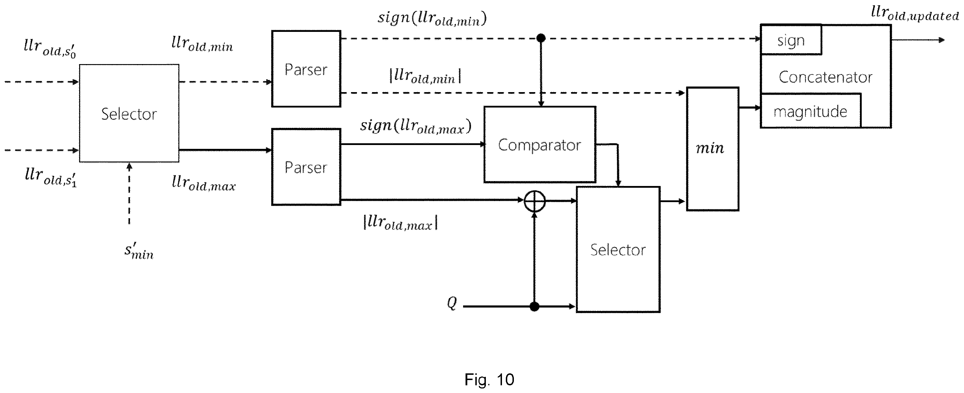

For simplicity, in the following, especially in Figs. 9 and 10, various embodiment will be elaborated in a simple example, where L=2 and the received samples are binary modulated, especially using non-return to zero on-off keying (NRZ-OOK) modulation. In this case, there are only two possible current states s=0 and s=1.

A skilled person shall understand that the modulation scheme is not limited thereto. Other modulation scheme, for example, PAM 4 may be used in other embodiments. A skilled person shall also understand that in other embodiments the L may be higher than 2.

Fig. 9 shows a schematic diagram showing the update procedure according to one embodiment.

Reference is first made to Fig. 5. Conventionally, for Viterbi based MLSE, for each possible previous state s', s'=1 and s'=0, there is a memory storing bit values of M previous bits. As shown in Fig. 5, hard decisions of bit values 0 or 1 are stored in respective memory.

According to various embodiments, there may be a memory storing llr values of M previous bits for each possible previous state s'. In the example shown in Fig. 9, there are only two states, s'=1 and s'=0. There are two memories respectively for each state, and each memory may have a depth of M llr positions, each llr position takes for example a predetermined number of bits in the memory, and stores a llr value of a transmitted bit associated with that state.

A skilled person shall understand that in other embodiments, there may be more than two possible states and the number of memories corresponds to the number of possible states of a sample.

For example, in case of four possible states, for example when L=3 and binary modulation is used, there may be four memories respectively for four possible states, and each memory may have a depth of M llr positions, each llr position stores a llr value of a transmitted bit.

Generally, the equalizer may obtain the llr values $llr_{old, min}$, $llr_{old,max}$ of the first transmitted bit $b_j$ respectively from the $m^{th}$ llr position of a memory corresponding to respective possible state s' of the received sample at the previous time step k-1; wherein, $1 \leq m \leq M$, M being related to length of the memory.

Specifically, as shown by the block drawn by dashed lines in Fig. 9, $b_{k-3}$ is considered as the first transmitted bit bj. The llr values of the first transmitted bit bj, $llr_{2\_old,s'0}$ and $llr_{2\_old,s'1}$ are respectively retrieved from the second llr position of the memories respectively corresponding to s'=0 and s'=1.

Given that s=0 is considered as the first possible state for the current state s, the most likely previous state s'min and the less likely previous state s'max may be determined based on various methods known to a skilled person. For example, one of s'=0 and s'=1 may be determined based on path metrics as the most likely previous state $s'_{min}$, while the other one may be determined as the less likely previous state s'max. Accordingly, $llr_{old, min}$, $llr_{old,max}$ may be selected from the obtained llr values of the first transmitted bit bj, $llr_{2\_old,s'0}$, and $llr_{2\_old,s'1}$. A skilled person should know various different scheme of determining the $llr_{old, min}$, $llr_{old,max}$ for a possible current state.

Fig. 10 shows a schematic block diagram of implementing llr updating according to one embodiment of the present invention.

Specifically, as shown in Fig. 10, the equalizer may retrieve the llr values $llr_{old,s_0'}$ and $llr_{old,s_1'}$ of the first transmitted bit bj respectively from the memory corresponding to each possible state s'=0 and s'=1. For simplicity, s'=0 may be denoted as $s'_0$, and s'=1 may be denoted as $s'_1$. Meanwhile, for each possible current state s, s=0 and s=1, the most likely previous state $s'_{min}$ may be determined based on the current PM values. Depending on the $s'_{min}$ value, one of the old llr values, $llr_{old,s_0'}$ or $llr_{old,s_1'}$ is selected as $llr_{old,min}$, the other one of the old llr values $llr_{old,s_1'}$ or $llr_{old,s_0'}$ is selected as $llr_{old,max}$.

$$llr_{old,min} = \log\left(\frac{P_{s'_{min},0}}{P_{s'_{min},1}}\right), llr_{old,max} = \log\left(\frac{P_{s'_{max},0}}{P_{s'_{max},1}}\right)$$

Returning to Fig. 8, in step S820, the equalizer according to various embodiments determines, based on path metrics and branch metrics corresponding to the received sample at the current time step k; a first parameter Q related to a difference between likelihoods of the most likely state $s'_{min}$ and the less likely state S'max.

In one embodiment, the first parameter Q may be a magnitude of a log-likelihood ratio $llr_{new}$ between the most likely state s'min and the less likely state s'max.

$$Q = |llr_{new}| = \log\left(\frac{P_{s'_{min}}}{P_{s'_{max}}}\right) = \log\left(\frac{\max\left(P_{s'_{min},0}, P_{s'_{min},1}\right)}{\max\left(P_{s'_{max},0}, P_{s'_{max},1}\right)}\right)$$

In one embodiment where the received samples are binary modulated, especially using non-return to zero on-off keying (NRZ-OOK) modulation, the first parameter may be a magnitude of a llr value of a second transmitted bit associated with the first possible state s, wherein, the second transmitted bit distinguishes the most likely state s'min from the less likely state s'max.

For example, referring to the trellis of states in Fig 3, given that the first possible current state s is "00" at time step k+1. Then the two possible previous states s' are "00" and "10" at time step k, which are the states having an arrow going into "00" at time step k+1. In the example shown in Fig. 3 the previous state s'=00 is the most likely state s'min and the previous state s'=10 is the less likely state s'max. There is only one bit difference between the two previous states s'min and s'$_{max}$. The first parameter Q may be a magnitude of a log-likelihood ratio llr$_{new}$ between the most likely state s'min and the less likely state s'max. In case of binary modulation, the llr$_{new}$ equals llr of the bit that distinguishes the most likely state s'$_{min}$ from the less likely state S'max.

Generally, at time step k, the position of the bit that distinguishes the most likely state s'min from the less likely state s'max is related to L and the modulation scheme used for the transmitted samples. For example, in case binary modulation is used, and L=3, considering at time step k, b$_k$ is the most recent bit in the current state s, the second transmitted bit that distinguishes the most likely previous state s'$_{min}$ from the less likely previous state s'max is b$_{k-L+1}$.

Specifically, in the simple example as shown in Fig. 9 or 10, where L=2 and the received samples are binary modulated, at time step k, the bit in the current state is b$_k$, the bit that distinguishes the most likely previous state s'$_{min}$ from the less likely previous state s'$_{max}$ is b$_{k-1}$. In the example shown in Fig. 3, at time step k, the bits in the current state is b$_{k-1}$b$_{k,}$ the bit that distinguishes the most likely state s'$_{min}$ from the less likely state s'$_{max}$ is b$_{k-2.}$

Still referring to Fig. 8, in step S830, the equalizer according to various embodiments updates the magnitude of the llr value llr$_{old, min}$ at least based on the llr value llr$_{old, min}$, the llr value llr$_{old,max}$, and the first parameter Q, thereby obtaining an updated llr value llr$_{old,updated}$.

Specifically, in one embodiment, the sign of *llr$_{old,min}$* may be preserved, the equalizer may reduce the magnitude of the llr value llr$_{old,min}$, at least based on the sign of the llr value llr$_{old, min}$, the llr value llr$_{old,max}$ and the first parameter Q.

Specifically, in one embodiment, the equalizer may determine whether the llr value llr$_{old, min}$ and the llr value llr$_{old,max}$ have the same sign. Based on determining the llr value llr$_{old, min}$ and the llr value llr$_{old,max}$ have the same sign, the magnitude of the updated llr value llr$_{old,updated}$ may be determined as the minimum of the magnitude the llr value llr$_{old, min}$ and the sum of the first parameter and the magnitude of the llr value llr$_{old,max}$. Based on determining the llr value llr$_{old, min}$ and the llr value llr$_{old,max}$ do not have the same sign, the magnitude of the updated llr value llr$_{old,updated}$ may be determined as the minimum of the magnitude of the llr value llr$_{old, min}$ and the first parameter.

In the example embodiment shown in Fig. 10, dashed lines represent the operation used in the SOVE algorithm. According to SOVE algorithm, for each current state s, only the old llr value of the most likely previous stat s' will be considered, thus the updated llr value would be taken as: *llr$_{old,updated}$* = *llr$_{old,min}$*, meaning that the llr values for the less likely states are discarded.

In the example embodiment shown in Fig. 10, solid lines represent the operation used according to various embodiments. While determining the updated llr value llr$_{old,updated}$, the likelihood of the less likely state llr$_{old,max}$ is taken into account as well, thereby the updated llr value llr$_{old,updated}$ for the first transmitted bit bj is calculated more accurately.

More specifically, in the example embodiment illustrated in Fig. 10, both *llr$_{old,min}$* and *llr$_{old,max}$* are then parsed into their sign and magnitudes, and their signs are compared. Depending on this comparison, selector will select Q or Q + |*llr$_{old,max}$*|. A min-block may then select the minimum of this result and |*llr$_{old,min}$*|. The resulting magnitude is the concatenated with *sign(llr$_{old,min}$)* to obtain the updated llr magnitude *llr$_{old,udpated}$*.

$$llr_{old,updated} = sign[llr_{old,min}] \min \left( \left| llr_{old,min} \right|, \right.$$

$$\left. Q + \sim xor[llr_{old,min} > 0, llr_{old,max} > 0] \left| llr_{old,max} \right| \right)$$

This is equivalent to the formula:

$$llr_{old,updated} \approx \log \left( \frac{\max \left( P_{s'_{min,0}}, P_{s'_{max,0}} \right)}{\max \left( P_{s'_{min,1}}, P_{s'_{max,1}} \right)} \right)$$

In case $P_{s'_{min,0}} \geq P_{s'_{min,1}}$, which implies that $P_{s'_{min,0}}$ is the highest of the four likelihoods. In this case the formula above can be simplified to:

$$llr_{old,updated} \approx \log \left( \frac{\max \left( P_{s'_{min,0}}, P_{s'_{max,0}} \right)}{\max \left( P_{s'_{min,1}}, P_{s'_{max,1}} \right)} \right) = \log \left( \frac{P_{s'_{min,0}}}{\max \left( P_{s'_{min,1}}, P_{s'_{max,1}} \right)} \right)$$

It also implies that $llr_{old,updated}$ and $llr_{old,min}$ are both positive, and that the sign is preserved. Depending on the relative magnitudes of the likelihoods, the magnitude of $llr_{old,updated}$ should be either taken as $|llr_{old,min}|$, Q, or $Q + |llr_{old,max}|$.

The same reasoning can be applied in case $P_{s'_{min,1}} > P_{s'_{min,0}}$.

After the updated llr value $llr_{old,updated}$ is obtained, in one embodiment, the equalizer may store the updated llr value $llr_{old,updated}$ into $m+1^{th}$ llr position of the further memory corresponding to the first possible state s of the received sample at the current time step k, when $1 \leq m < M$.

In the example shown in Fig. 9 there are two further memories respectively corresponding to each possible state at the current time step k. Similar as explained above, each further memory may have a depth of M llr positions, each llr position takes for example a predetermined number of bits in the memory, and stores a llr value of a transmitted bit associated with that state. Specifically referring to Fig. 9, for the first possible state s=0, the updated llr value $llr_{2\_updated}$ $s_0$ of the first transmitted bit $b_{k-3}$ may be stored in the third llr position of the further memory corresponding to the first possible state s=0, as represented by the solid arrow. Thereby, the llr values of a transmitted bit is shifted after update by one llr position in the memory.

The above description only concentrates on updating the llr value of one transmitted bit for one possible state. However, since each transmitted bit may be considered independently, a skilled person shall understand, the described obtaining S810, determining S820 and updating S830 procedure may be repeated for a predetermined number M of transmitted bits.

Referring to the example embodiment shown in Fig. 9, the described obtaining S810, determining S820 and updating S830 procedure may be repeated for each of the M bits $b_{k-2}$, $b_{k-3}$ and $b_{k-1-M}$.

Furthermore, the described obtaining S810, determining S820 and updating S830 procedure may be repeated for respective possible state s of the received sample at the current time step k.

Referring to the example embodiment shown in Fig. 9, the solid arrows represent the update procedure performed for state s=0. The dashed arrow represents the update for s=1. The update procedure for the same transmitted bit may require same set of old llr values of that transmitted bit, however, the update procedure may be performed independently for different possible current states. Specifically, based on the same input, $llr_{2\_old,s'0}$ and $llr_{2\_old,s'1}$, the most likely previous state s'min and a less likely previous state $s'_{max}$ may be determined differently for the possible current states s=0 and s=1. Then the llr update may be performed independently for both s=0 and s=1 similarly as described above.

As shown by the dashed arrow in Fig. 9, for current state s=1, the updated llr value $llr_{2\_updated, s1}$ of the first transmitted bit $b_{k-3}$ may be stored in the third llr position of the memory corresponding to the first possible state s=1.

A skilled person may easily amend the examples shown in Figs. 9 and 10 to adapt for other embodiments with more possible states for example in case of higher L or PAM 4 modulation. For example, as shown in the example in Fig. 3, there are four possible states, s=0, s=1, s=2 and s=3, the equalizer may repeat the described obtaining S810, determining S820 and updating S830 procedure for respective possible state s=0, s=1, s=2 and s=3 of the received sample at the current time step.

In one embodiment where binary modulation is used and the first parameter Q is a magnitude of a llr value of a second transmitted bit associated with the first possible state s, wherein, the second transmitted bit distinguishes the most likely state s'min from the less likely state $s'_{max}$, the equalizer may store the llr value of the second transmitted bit $llr_{new}$ into the first llr position of the further memory corresponding to the first possible state s of the received sample at the current time step k.

Specifically, reference is made to the embodiment shown in Fig. 9, at time step k, the bit in the current state is $b_k$, and the second transmitted bit that distinguishes the most likely state s'min from the less likely state $s'_{max}$ is $b_{k-1}$. The llr values of the second transmitted bit $b_{k-1}$, $llr_{new,s0}$, $llr_{new,s1}$ respectively for s=0 and s=1, may be stored in the first llr position of the further memories corresponding to respective possible current states.

In one embodiment, the equalizer may determine whether the obtained llr values $llr_{old, min}$, $llr_{old,max}$ are retrieved from the last llr position of the memory, namely whether m=M and the equalizer may determine whether the first possible state s is the most likely state $s_{min}$ related to the received sample at the current time step k; based on determining the first possible state s is the most likely state $s_{min}$, and m=M, the equalizer may output the updated llr value $llr_{old,updated}$ and FEC decoding may be further performed, for example, by an FEC decoder, based on the output llr value $llr_{old,updated}$.

Specifically, referring to the embodiment shown in Fig. 9, the updated llr value of the transmitted bit, the old llr

values of which were obtained from the M$^{th}$ llr position of the memory, may be stored as temporary output of the corresponding current state s. Then, one of the possible current states s=0 or s=1 may be determined as the most likely state s$_{min}$ related to the received sample at the current time step k, for example, based on path metrics. Specifically, the most likely state may be determined as the one with the minimal PM. A skilled person should know other scheme to determine the most likely current state s$_{min}$. The temporary output corresponding to most likely current state may be provided as output of the equalizer, and provided further to a FEC decoder. The FEC decoder may perform FEC decoding based on the llr value output by the equalizer.

The storage of the temporary output may be optional. For example, the equalizer may first determine which one of the possible states is the most likely state s$_{min}$ related to the received sample at the current time step k, and then perform the update procedure for the oldest transmitted bit considering the most likely current state s$_{min}$ is the current state. The updated llr value of the oldest transmitted bit and associated with the most likely current state s$_{min}$ is directly provided as output of the equalizer.

In one example, the further memories corresponding to the current states may reuse the memories corresponding to the previous states. For example, the update procedure may be performed first for the oldest one among the transmitted bits, the llr values of which are stored in the memories corresponding to the previous states. For example, in Fig. 9, the update is first performed for the oldest transmitted bit b$_{k-1-M}$. After update, the updated llr value llr$_{M\_updated,Smin}$ associated with the most likely current state s$_{min}$ may be output to the FEC decoder as described above Then the update procedure may be repeated for other transmitted bits in an order of increasing reception time, b$_{k-M}$, b$_{k-M+1}$ ... b$_{k-2}$. After update, the llr values of each transmitted bit may be shifted by one llr position in the memory towards the llr position corresponding to the oldest transmitted bit. The first llr position of the further memory is filled with llr value of the second transmitted bit llr$_{new}$.

In other examples, the further memories corresponding to the possible current state s may be different from the memories corresponding to respective possible previous state s'. For example, the update procedure may be repeated in arbitrary order for all the transmitted bits and the updated llr values may be stored in the further memory different from the memories corresponding to respective possible previous state s', where the old llr values were stored. After llr values of all the transmitted bits are updated, the content in the further memory may be rewritten into the memory corresponding to the respective previous state s'. The current state s becomes the previous state s'.

In some embodiments, for each possible current state s, there may be more than two possible previous states, for example in case of higher-order modulation formats, like PAM3, PAM4 or PAM8. One of the possible previous states may be determined as the most likely state, the other possible previous states may be all determined as less likely states. The equalizer may repeat the obtaining S810, determining S820 and updating S830 for respective less likely state of the received sample at a previous time step k-1.

For example, in case there are four previous states, namely four $s'_0$, $s'_1$, $s'_2$ and $s'_3$ in case of the PAM4 example, there will be one most likely state $s'_{min}$ and 3 less likely states $s'_{max,1}$, $s'_{max,2}$, and $s'_{max,3}$. Now, for each less likely state $s'_{max,j}$ a first parameter Qj can be defined, which corresponds to the ratio of the highest likelihoods of $s'_{min}$ and $s'_{max,j}$:

$$Q_j = \log\left(\frac{\max\left(P_{s'_{min},0}, P_{s'_{min},1}\right)}{\max\left(P_{s'_{max,j},0}, P_{s'_{max,j},1}\right)}\right)$$

The update formula then becomes:

$$llr_{old,updated} = sign\left(llr_{old,min}\right)\min\left(\left|llr_{old,min}\right|,\right.$$

$$Q_1 + \sim xor\left(llr_{old,min} > 0, llr_{old,max,1} > 0\right)\left|llr_{old,max,1}\right|,$$

$$Q_2 + \sim xor\left(llr_{old,min} > 0, llr_{old,max,2} > 0\right)\left|llr_{old,max,2}\right|,$$

$$Q_3 + \sim xor\left(llr_{old,min} > 0, llr_{old,max,3} > 0\right)\big|llr_{old,max,3}\big|\big)$$

One way to implement this is to apply the processing of Fig. 10. **Fehler! Verweisquelle konnte nicht gefunden werden.** three times serially in a row, once for each less likely state. For instance, first the processing of Fig. 10 would be applied on inputs $llr_{old,min}$ and $llr_{old,max,1}$ leading to an intermediate result $llr_{result,1}$. Then, the same processing is applied on inputs $llr_{result,1}$ and $llr_{old,max,2}$, leading to the intermediate result $llr_{result,2}$, and then again on $llr_{result,2}$ and $llr_{old,max,3}$ finally leading to the output result $llr_{old,updated}$. Alternatively, the update could only be done for one of the less likely states (e.g., for one to most likely state, i.e., the one with the smallest $Q_j$), or for two of the less likely states (e.g., for the one to and second to most likely states). This lowers the complexity but at the price of reduced performance.

This proposed processing yields a performance close to that of the BCJR algorithm. It does so at a much lower complexity, as only a single pass through the trellis is required. Also, not all the path metrics have to be stored in memory, but only the last M sets of llrs, which reduces the memory requirement significantly.

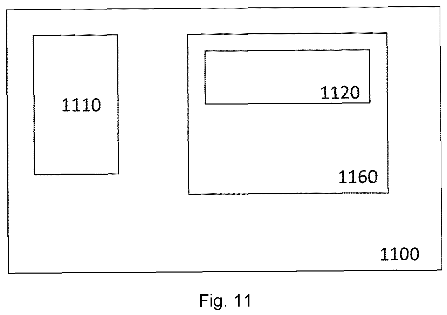

Fig. 11 shows a block diagram of an apparatus according to various embodiments.

Specifically, Fig. 11 depicts the apparatus 1100 operating in accordance with an example embodiment of the invention. The apparatus 1100 may be, for example, an electronic device, or a receiver in a communication link. In one example, the apparatus 1100 may be implemented in an OLT 110, or in an ONU 121, 122, 123. The apparatus 1100 includes a processor 1110 and a memory 1160. In other examples, the apparatus 200 may comprise multiple processors.

In the example of Fig. 11, the processor 1110 is a control unit operatively connected to read from and write to the memory 1160. The processor 1110 may also be configured to receive control signals received via an input interface and/or the processor 1110 may be configured to output control signals via an output interface. In an example embodiment, the processor 1110 may be configured to convert the received control signals into appropriate commands for controlling functionalities of the apparatus 1100.

The memory 1160 stores computer program instructions 1120 which when loaded into the processor 1110 control the operation of the apparatus 1100 as explained above. In other examples, the apparatus 1100 may comprise more than one memory 1160 or different kinds of storage devices.

Computer program instructions 1120 for enabling implementations of example embodiments of the invention or a part of such computer program instructions may be loaded onto the apparatus 1100 by the manufacturer of the apparatus 1100, by a user of the apparatus 1100, or by the apparatus 1100 itself based on a download program, or the instructions can be pushed to the apparatus 1100 by an external device. The computer program instructions may arrive at the apparatus 1100 via an electromagnetic carrier signal or be copied from a physical entity such as a computer program product, a memory device or a record medium such as a Compact Disc (CD), a Compact Disc Read- Only Memory (CD-ROM), a Digital Versatile Disk (DVD) or a Blu-ray disk.

According to an example embodiment, the apparatus 1100 comprises means for performing, wherein the means for performing comprises at least one processor 1110, at least one memory 1160 including computer program code 220, the at least one memory 1160 and the computer program code 1120 configured to, with the at least one processor 1110, cause the performance of the apparatus 1100.

Embodiments of the present invention may be implemented in software, hardware, application logic or a combination of software, hardware and application logic. The software, application logic and/or hardware may reside on the apparatus, a separate device or a plurality of devices. If desired, part of the software, application logic and/or hardware may reside on the apparatus, part of the software, application logic and/or hardware may reside on a separate device, and part of the software, application logic and/or hardware may reside on a plurality of devices. In an example embodiment, the application logic, software or an instruction set is maintained on any one of various conventional computer-readable media. In the context of this document, a 'computer- readable medium' may be any media or means that can contain, store, communicate, propagate or transport the instructions for use by or in connection with an instruction execution system, apparatus, or device, such as a computer, with one example of a computer described and depicted in Fig. 11. A computer-readable medium may comprise a computer-readable storage medium that may be any media or means that can contain or store the instructions for use by or in connection with an instruction execution system, apparatus, or device, such as a computer.

If desired, the different functions discussed herein may be performed in a different order and/or concurrently with each other. Furthermore, if desired, one or more of the above-described functions may be optional or may be combined.

Although various aspects of the invention are set out in the independent claims, other aspects of the invention comprise other combinations of features from the described embodiments and/or the dependent claims with the features of the independent claims, and not solely the combinations explicitly set out in the claims.

It will be obvious to a person skilled in the art that, as the technology advances, the inventive concept can be implemented in various ways. The invention and its embodiments are not limited to the examples described above but may vary within the scope of the claims.

**Claims**

1. An apparatus, comprising means for performing:

   - obtaining, by an equalizer based on Viterbi algorithm in a receiver in a communication link, for a first possible state (s) of a received sample at the current time step (k), log-likelihood ratio, llr, values $llr_{old, min}$, $llr_{old,max}$ of a first transmitted bit (bj), wherein, the llr values $llr_{old, min}$, $llr_{old,max}$ are respectively associated with a most likely state ($s'_{min}$) and a less likely state ($s'_{max}$) related to a received sample at the previous time step (k-1);
   - determining, by the equalizer, based on path metrics and branch metrics corresponding to the received sample at the current time step (k); a first parameter (Q) related to a difference between likelihoods of the most likely state ($s'_{min}$) and the less likely state ($s'max$);
   - updating, by the equalizer, magnitude of the llr value $llr_{old, min}$ at least based on the llr value $llr_{old, min}$, the llr value $llr_{old,max}$, and the first parameter, thereby obtaining an updated llr value $llr_{old,updated}$.

2. The apparatus of any preceding claim, wherein the means for performing updating comprises means for performing:

   - reducing the magnitude of the llr value $llr_{old,min}$, at least based on the sign of the llr value $llr_{old, min}$, the llr value $llr_{old,max}$ and the first parameter.

3. The apparatus of any preceding claim, wherein the means for performing updating comprises means for performing:

   - determining whether the llr value $llr_{old, min}$ and the llr value $llr_{old,max}$ have the same sign;
   - based on determining the llr value $llr_{old, min}$ and the llr value $llr_{old,max}$ have the same sign, determining the magnitude of the updated llr value $llr_{old,updated}$ as the minimum of the magnitude the llr value $llr_{old, min}$ and the sum of the first parameter (Q) and the magnitude of the llr value $llr_{old,max}$;
   - based on determining the llr value $llr_{old, min}$ and the llr value $llr_{old,max}$ do not have the same sign, determining the magnitude of the updated llr value $llr_{old,updated}$ as the minimum of the magnitude of the llr value $llr_{old, min}$ and the first parameter (Q).

4. The apparatus of any preceding claim, wherein the means for performing are further configured for:

   - repeating the obtaining, determining and updating for a predetermined number M of transmitted bits.

5. The apparatus of any preceding claim, wherein the means for performing are further configured for:

   - repeating the obtaining, determining and updating for respective possible state (s) of the received sample at the current time step (k).

6. The apparatus of any preceding claim, wherein, the first parameter is a magnitude of a log-likelihood ratio ($llr_{new}$) between the most likely state ($s'_{min}$) and the less likely state ($s'_{max}$).

7. The apparatus of any preceding claim, wherein, the means for performing are further configured for:

   - obtaining, the llr values $llr_{old, min}$, $llr_{old,max}$ of the first transmitted bit (bj) respectively from the $m^{th}$ llr position of a memory corresponding to respective possible state (s') of the received sample at the previous time step (k-1); wherein, $1 \leq m \leq M$, M being related to length of the memory.

8. The apparatus of the preceding claim, wherein, the means for performing are further configured for:

   - storing the updated llr value $llr_{old,updated}$ into the $m+1^{th}$ llr position of a further memory corresponding to the first possible state (s) of the received sample at the current time step (k), when $1 \leq m < M$.

9. The apparatus of claim 7, wherein, the means for performing are further configured for:

   - determining whether the first possible state (s) is the most likely state ($s_{min}$) related to the received sample at the current time step (k) and whether m=M;
   - based on determining the first possible state (s) is the most likely state ($s_{min}$), and m=M, outputting the updated llr value ($llr_{old,updated}$) and performing FEC decoding based on the output llr value ($llr_{old,updated}$).

10. The apparatus of any preceding claim, wherein the received samples are modulated according to any one of:

a binary modulation scheme, especially the non-return to zero on-off keying (NRZ-OOK) modulation, and PAM 4 modulation.

11. The apparatus of the preceding claim, wherein the received samples are binary modulated, especially using non-return to zero on-off keying (NRZ-OOK) modulation, the first parameter is a magnitude of a llr value ($llr_{new}$) of a second transmitted bit associated with the first possible state (s), wherein, the second transmitted bit distinguishes the most likely state ($s'_{min}$) from the less likely state ($s'_{max}$).

12. The apparatus of claims 8 and 11, wherein the means for performing are further configured for:

- storing, the llr value ($llr_{new}$) of the second transmitted bit into the first llr position of the further memory corresponding to the first possible state (s) of the received sample at the current time step (k).

13. The apparatus of any of claims 1-9, wherein the means for performing are further configured for:

- repeating the obtaining, determining and updating for respective less likely state ($s'_{max1}$, $s'_{max2}$, $s'_{max3}$) of the received sample at a previous time step (k-1).

14. A method comprising:

- obtaining, by an equalizer based on Viterbi algorithm in a receiver in a communication link, for a first possible state (s) of a received sample at the current time step (k), log-likelihood ratio, llr, values $llr_{old, min}$, $llr_{old,max}$ of a first transmitted bit (bj), wherein, the llr values $llr_{old, min}$, $llr_{old,max}$ are respectively associated with a most likely state ($s'_{min}$) and a less likely state ($s'_{max}$) related to a received sample at a previous time step (k-1);
- determining, by the equalizer, based on path metrics and branch metrics corresponding to the received sample at the current time step (k); a first parameter related to a difference between likelihoods of the most likely state ($s'_{min}$) and the less likely state ($s'_{max}$);
- updating, by the equalizer, magnitude of the llr value $llr_{old, min}$ at least based on the llr value $llr_{old, min}$, the llr value $llr_{old,max}$, and the first parameter, thereby obtaining an updated llr value $llr_{old,updated}$.

15. A computer program comprising instructions which, when the program is executed by a computer, cause the computer to carry out:

- obtaining, by an equalizer based on Viterbi algorithm in a receiver in a communication link, for a first possible state (s) of a received sample at the current time step (k), log-likelihood ratio, llr, values $llr_{old, min}$, $llr_{old,max}$ of a first transmitted bit (bj), wherein, the llr values $llr_{old, min}$, $llr_{old,max}$ are respectively associated with a most likely state ($s'_{min}$) and a less likely state ($s'_{max}$) related to a received sample at a previous time step (k-1);
- determining, by the equalizer, based on path metrics and branch metrics corresponding to the received sample at the current time step (k); a first parameter related to a difference between likelihoods of the most likely state ($s'_{min}$) and the less likely state ($s'_{max}$);
- updating, by the equalizer, magnitude of the llr value $llr_{old, min}$ at least based on the llr value $llr_{old, min}$, the llr value $llr_{old,max}$, and the first parameter, thereby obtaining an updated llr value $llr_{old,updated}$.

Fig. 1

Fig. 2

Fig. 3

Fig. 4

State after previous step

Copy memory from min state

Shift memory

Fig. 5

Fig. 6a

Fig. 6b

Received samples → BM calculations → BMs → Path metric Unit

Path metric Unit: Delay, Delay, Min and Diff, Min and Diff, PM$_0$, PM$_1$, Min val, Difference, Min, llr$_0$, llr$_1$, Memory, Min state → llr$_{out}$

Fig. 7

obtaining llr values $\text{llr}_{\text{old, min}}$, $\text{llr}_{\text{old,max}}$ of a first transmitted bit $b_j$     S810

determining a first parameter related to a difference between likelihoods of the most likely state $s'_{\text{min}}$ and the less likely state $s'_{\text{max}}$     S820

updating magnitude of the llr value $\text{llr}_{\text{old, min}}$ at least based on the llr value $\text{llr}_{\text{old, min}}$, the llr value $\text{llr}_{\text{old,max}}$, and the first parameter     S830

Fig. 8

$b_{k-2}$    $b_{k-3}$    $b_{k-4}$    ...    $b_{k-M}$    $b_{k-1-M}$

s'=0
| llr1 | llr2 | llr3 | | llr$_{M-1}$ | llr$_M$ |
| Old, $s_0'$ | Old, $s_0'$ | Old, $s_0'$ | ... | Old, $s_0'$ | Old, $s_0'$ |

s'=1
| llr1 | llr2 | llr3 | | llr$_{M-1}$ | llr$_M$ |
| Old, $s_1'$ | Old, $s_1'$ | Old, $s_1'$ | ... | Old, $s_1'$ | Old, $s_1'$ |

llr update

$b_{k-1}$    $b_{k-2}$    $b_{k-3}$    ...    $b_{k-M+1}$    $b_{k-M}$

s=0
| llr | llr1 | llr2 | | llr$_{M-2}$ | llr$_{M-1}$ |
| New, $s_0$ | updated, $s_0$ | updated, $s_0$ | ... | updated, $s_0$ | updated, $s_0$ |

s=1
| llr | llr1 | llr2 | | llr$_{M-2}$ | llr$_{M-1}$ |
| New, $s_1$ | updated, $s_1$ | updated, $s_1$ | ... | updated, $s_1$ | updated, $s_1$ |

output

+

$b_{k-1-M}$

| llr$_M$ |
| updated, $s_{min}$ |

Fig. 9

Fig. 10

Fig. 11

Europäisches
Patentamt

European
Patent Office

Office européen
des brevets

# EUROPEAN SEARCH REPORT

Application Number

EP 22 19 6395

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KLAIMI RAMI ET AL: "Simplified recursion units for Max-Log-MAP: New trade-offs through variants of Local-SOVA", 2021 11TH INTERNATIONAL SYMPOSIUM ON TOPICS IN CODING (ISTC, IEEE, 30 August 2021 (2021-08-30), pages 1-5, XP034018234, DOI: 10.1109/ISTC49272.2021.9594265 [retrieved on 2021-10-28] * section II.B * | 1-15 | INV. H04L25/03 ADD. H03M13/41 H03M13/00 |
| A | SHIMOMURA KAZUKI ET AL: "Multiple Differential Detection with Channel Prediction Employing Soft-Output Per-Survivor Processing", 2018 ASIA-PACIFIC SIGNAL AND INFORMATION PROCESSING ASSOCIATION ANNUAL SUMMIT AND CONFERENCE (APSIPA ASC), APSIPA ORGANIZATION, 12 November 2018 (2018-11-12), pages 153-158, XP033525964, DOI: 10.23919/APSIPA.2018.8659608 [retrieved on 2019-03-04] * section IV * | 1-15 | |
| A | RHA HAE YOUNG ET AL: "Low-Complexity Soft-Decision Viterbi Algorithm for IM/DD 56-Gb/s PAM-4 System", IEEE PHOTONICS TECHNOLOGY LETTERS, IEEE, USA, vol. 31, no. 5, 1 March 2019 (2019-03-01), pages 361-364, XP011713434, ISSN: 1041-1135, DOI: 10.1109/LPT.2019.2893380 [retrieved on 2019-03-05] * section II * | 1-15 | |

TECHNICAL FIELDS
SEARCHED (IPC)

H04L
H03M

The present search report has been drawn up for all claims

| Place of search | Date of completion of the search | Examiner |
|---|---|---|
| Munich | 9 February 2023 | El Hajj Shehadeh, Y |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)